# EUROPEAN PATENT APPLICATION

(11) **EP 4 328 980 A1**
(43) Date of publication of application: **28.02.2024**
(21) Application number: 22930029.8
(22) Date of filing: 26.09.2022
(51) Int. Cl.: H01L 31/0224, H01L 31/0236, H01L 31/18

(54) **SOLAR CELL AND MANUFACTURING METHOD THEREFOR**

(30) Priority: 03.03.2022 KR 20220027200
(71) Applicant: Shangrao Xinyuan YueDong Technology Development Co. Ltd, Jiangxi 334100 (CN)
(72) Inventor: AHN, Junyong, Seoul 06772 (KR); JUNG, Youngbae, Seoul 06772 (KR); JUNG, Ilhyoung, Seoul 06772 (KR); KIM, Sungjin, Seoul 06772 (KR); KIM, Oksik, Seoul 06772 (KR)
(74) Representative: Botti & Ferrari S.p.A.
(86) International application number: PCT/KR2022/014312
(87) International publication number: WO 2023/167385

(57) **Abstract**

A solar cell according to some embodiments of the present disclosure includes a tunneling layer located on one side of a semiconductor substrate, a first conductive region located on the tunneling layer, a first insulating film located on and passivating the first conductive region, a second conductive region located at the other side of the semiconductor substrate and composed of a doping region, a first electrode connected to the first conductive region, and a second electrode connected to the second conductive region. The first conductive region includes a first part connected to the first electrode and a second part other than the first part, and a thickness of the first part is different from that of the second part. Therefore, in order to maintain a tunneling effect, a conductive region with different thicknesses is formed on a thin tunneling layer, so that a thick conductive region is below the electrode, and a thin conductive region is in the region other than the thick conductive region.

## Description

### TECHNICAL FIELD

The present disclosure relates to a solar cell and a manufacturing method thereof, and in particular, to a solar cell including a semiconductor substrate and a manufacturing method thereof.

### BACKGROUND

Recently, with expected depletion of existing energy resources such as oil and coal, interest in alternative energy sources is increasing. Solar cells are attracting attention as next-generation batteries that convert sunlight energy into electricity.

Such solar cells may be manufactured by forming various layers and electrodes according to designs. In the solar cells, efficiency may vary depending on the designs of various layers and electrodes. For commercialization of the solar cells, there is a need to maximize the efficiency of the solar cells and simplify a manufacturing method.

In particular, a structure in which a thin dielectric film is formed on a semiconductor substrate so as to achieve a tunneling effect and a polycrystalline semiconductor layer is formed on the thin dielectric film to form a conductive region is proposed.

In an example disclosed in Chinese Patent Publication No. 110265494, a solar cell includes a tunneling oxide film and a back surface field (BSF) region composed of an N-type polycrystalline semiconductor layer, recombination on the back surface is reduced and the photoelectric efficiency is improved by blocking flowing of minority carriers.

However, in the solar cell having the tunneling effect as described above, due to the thickness of the polycrystalline semiconductor layer doped with high concentration, concentration of doped carriers on the surface is very high, and free carrier absorption (FCA) occurs, thereby causing a significant reduction in long-wavelength absorption efficiency.

### Prior art reference

### Patent reference

Chinese Patent Publication No. 110265494 (published on September 20, 2019)

### SUMMARY

### Technical Problem

The present disclosure provides a solar cell with excellent efficiency and reliability and a manufacturing method thereof. In particular, the present disclosure provides a solar cell that can prevent long-wavelength absorption (FCA) while maintaining a tunneling effect.

In addition, the present disclosure provides a structure in which the conductive region has different thicknesses. A region of the conductive region under the electrode has a less thickness for preventing long-wavelength absorption, and other region of the conductive region has a larger thickness for maintaining a tunneling effect.

### Technical Solution

A solar cell according to embodiments of the present disclosure includes a tunneling layer located on one side of a semiconductor substrate, a first conductive region located on the tunneling layer, a first insulating film located on and passivating the first conductive region, a second conductive region located at the other side of the semiconductor substrate and formed by a doping region, a first electrode connected to the first conductive region, and a second electrode connected to the second conductive region. The first conductive region includes a first part connected to the first electrode and a second part other than the first part, and thicknesses of the first part and the second part are different from each other.

A width of the first part may be greater than that of the first electrode.

The thickness of the first part may be greater than that of the second part.

The thickness of the first part may range from 100 nm to 200 nm.

The thickness of the second part may be less than 50 nm.

The first conductive region may be arranged on a back surface of the semiconductor substrate and be doped with a dopant of a same conductivity type as the semiconductor substrate.

One side and the other side of the semiconductor substrate may be formed with unevenness.

A second insulating film located on the second conductive region may be further included.

In addition, some other embodiments of the present disclosure provide method for manufacturing a solar cell. The method for manufacturing a solar cell includes: a step of forming tunneling layers on one side and the other side of a semiconductor substrate respectively; a step of forming an intrinsic semiconductor layer on the tunneling layer on one side of the semiconductor substrate, and doping the intrinsic semiconductor layer with a first-conductivity-type dopant to form a first conductive region; a step of selectively partially etching a second part of the first conductive region other than a first part to form a step; a step of doping the other side of the semiconductor substrate with a second-conductivity-type dopant to form a second conductive region composed of a doping region; a step of forming a first insulating film covering the first conductive region; and a step of forming electrodes which include a first electrode connected to the first part of the first conductive region and a second electrode connected to the second conductive region.

The step of forming a step in the first conductive region may include: a step of forming a mask layer on the first part; a step of removing, using an etching solution, the exposed second part of the first conductive region to a predetermined thickness; and a step of removing the mask layer.

The step of forming a step in the first conductive region may include: a step of irradiating the first part of the first conductive region with laser to change a crystalline structure; and a step of etching the second part to the predetermined thickness.

In the step of forming a step in the first conductive region, the first conductive region may be immersed in an alkaline solution to be etched to have the step.

A step of forming unevenness on two sides of the semiconductor substrate may be further included.

A width of the first part may be formed to be greater than a width of the first electrode.

The step of forming a first electrode may include: a step of coating the first insulating film on the first part with a metal paste; and a step of firing through the metal paste such that the metal paste penetrates through the first insulating film and is in contact with the first part.

### Advantageous Effects

According to this embodiment, a solar cell with excellent efficiency and reliability and a manufacturing method thereof are provided.

That is, in order to maintain a tunneling effect, a conductive region with a variable thickness is formed on a thin tunneling layer, so that a thick conductive region is below an electrode, and a thin conductive region is in the other region.

Therefore, the tunneling layer below the electrode is protected from penetration of a lower film due to sintering of the electrode, and structural stability and composite stability can be achieved to maintain the tunneling effect as it is.

In addition, a thin conductive region is also arranged in the region other than below the electrode, sheet resistance to carriers is significantly reduced to improve photoelectric efficiency, and a thick conductive region is not formed for a wide region, thereby preventing long-wavelength absorption due to free carriers and then minimizing an optical loss.

Therefore, an effect of increasing an open-circuit voltage and a short-circuit current is achieved to improve the photoelectric efficiency.

### BRIEF DESCRIPTION OF DRAWINGS

FIG. 1 is a cross-sectional view of a solar cell according to some embodiments of the present disclosure;
FIG. 2 is a plan view of a second electrode layer of the solar cell shown in FIG. 1;
FIG. 3 is a cross-sectional view of a solar cell according to some embodiments of the present disclosure;
FIG. 4a to FIG. 4j are cross-sectional views showing a method for manufacturing a solar cell according to some embodiments of the present disclosure;
FIG. 5 is a cross-sectional view of a process of a method for manufacturing a solar cell according to a modified example of the present disclosure;
FIG. 6a and FIG. 6b are cross-sectional views of a region below an electrode according to the present disclosure; and
FIG. 7a and FIG. 7b are graphs for long-wavelength absorption on a surface of a conductive region and graphs showing a sheet resistance according to a thickness of the conductive region.

### Reference signs

100: solar cell
20: first conductive region
30: second conductive region
22: tunneling layer
42: first electrode
44: second electrode

### DESCRIPTION OF EMBODIMENTS

Embodiments of the present disclosure will be described in detail below with reference to the accompanying drawings. However, the present disclosure is not limited to such embodiments, and may be modified into various forms.

In order to clearly and briefly explain the present disclosure, illustration of parts irrelevant to the description in the accompanying drawings is omitted, and throughout the specification, same reference signs are used for same or very similar parts. In addition, in order to make the description clearer, the thickness, the width, and the like are enlarged or reduced and shown in the accompanying drawings, and the thickness, the width, and the like in the present disclosure are not limited to those shown in the accompanying drawings.

Moreover, when a certain part "includes" another part throughout the specification, other parts are not excluded unless otherwise stated, and other parts may be further included. In addition, when parts such as a layer, a film, a region, or a plate is referred to as being "on" another part, it may be "directly on" another part or may have another part present therebetween. In addition, when a part of a layer, film, region, plate, etc., is "directly on" another part, it means that no other part is positioned therebetween. In addition, the expression "first" or "second" is used only to distinguish one from another, and the present disclosure is not limited thereto.

A solar cell module and a manufacturing method thereof according to embodiments of the present disclosure will be described in detail below with reference to the accompanying drawings.

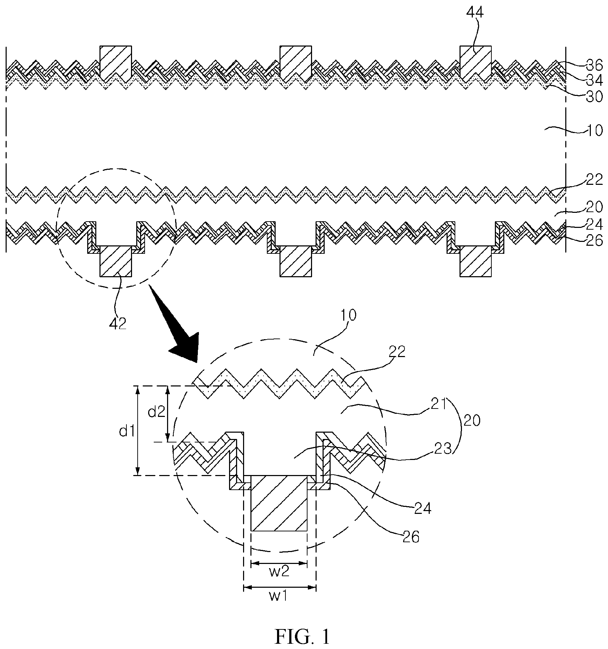

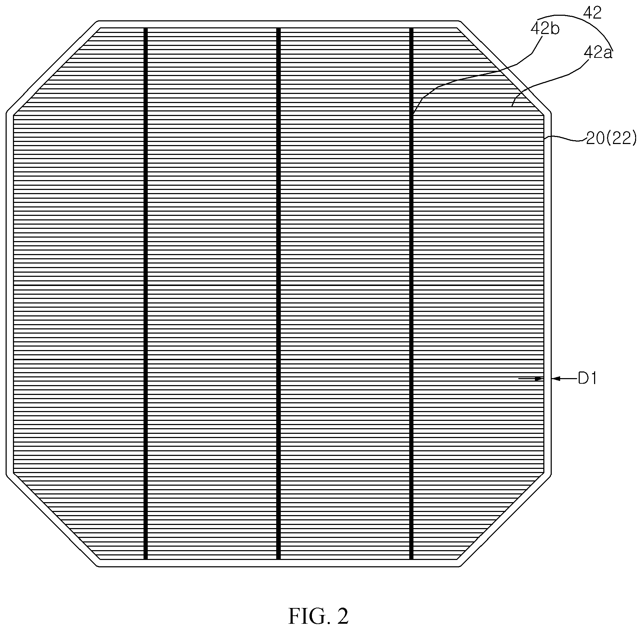

FIG. 1 is a cross-sectional view of a solar cell according to some embodiments of the present disclosure, and FIG. 2 is a schematic rear plan view of the solar cell shown in FIG. 1.

Referring to FIG. 1, a solar cell 100 may include a semiconductor substrate 110, a first conductive region 20 on one side of the semiconductor substrate 110 and having a first conductivity type, and a second conductive region 30 on the other side of the semiconductor substrate 110 and having a second conductivity type. Electrodes 42 and 44 include a first electrode 42 connected to the first conductive region 20 and a second electrode 44 connected to the second conductive region 30. In addition, the solar cell 100 may further include insulating films such as a first passivation film 24, a second passivation film 34, a first antireflection film 26, and a second antireflection film 36. Detailed descriptions thereof will be provided.

The semiconductor substrate 110 may be composed of a crystalline semiconductor including a single semiconductor material (a Group-IV element as an example). As an example, the semiconductor substrate 110 may be composed of a monocrystalline or polycrystalline semiconductor (monocrystalline or polycrystalline silicon as an example). In particular, the semiconductor substrate 110 may be composed of a monocrystalline semiconductor (e.g., a monocrystalline semiconductor wafer, a monocrystalline silicon wafer in an embodiment). When the semiconductor substrate 110 is composed of a monocrystalline semiconductor (e.g., monocrystalline silicon) as described above, the solar cell 100 will be based on the semiconductor substrate 110 composed of a monocrystalline semiconductor with high crystallinity and few defects. Accordingly, the solar cell 100 may have excellent electrical properties.

A front surface and/or a back surface of the semiconductor substrate 110 may be textured to have unevenness. The uneven structure may have, for example, a pyramid shape in which a surface constituting the outer surface of the semiconductor substrate 110 is configured as a (111) surface of the semiconductor substrate 110 and has an irregular size. Thereby, when surface roughness of a front surface of the semiconductor substrate 110 is relatively large, reflectance of light incident on the front surface of the semiconductor substrate 110 may be lowered. However, the present disclosure is not limited thereto. Therefore, an amount of light reaching a pn junction formed by a base region 10 and the first conductive region 20 or the second conductive region 30 can be increased, so that a light loss can be minimized. In this embodiment, it is exemplified that reflection of light incident on the front surface and the back surface is effectively prevented by forming unevenness on the front surface and the back surface of the semiconductor substrate 110.

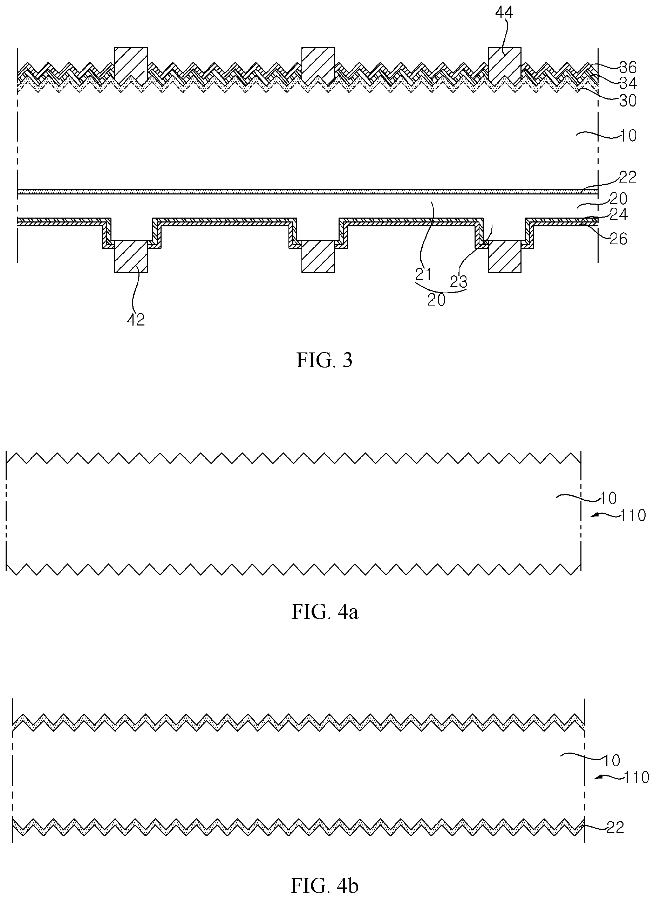

However, the present disclosure is not limited thereto. As shown in FIG. 3, the unevenness may be formed only on the front surface of the semiconductor substrate 110, and no unevenness is formed on the back surface of the semiconductor substrate 110. Accordingly, the back surface of the semiconductor substrate 110 on which a tunneling layer 22 is formed to have less surface roughness than the front surface, so that the tunneling layer 22 can be formed more stably and uniformly. In some embodiments, various modifications are possible in which no unevenness and the like is formed on the front surface and the back surface of the semiconductor substrate 110.

Referring to FIG. 1 again, in this embodiment, the semiconductor substrate 110 includes a base region 10 doped with a first-conductivity-type dopant or a second-conductivity-type dopant at a low doping concentration to have a first conductivity type or a second conductivity type. In this case, the base region 10 of the semiconductor substrate 110 may have lower doping concentration, higher resistance, or lower carrier concentration than one of the first conductive region 20 and the second conductive region 30 having a same conductivity type as the base region 10.

The first conductive region 20 having the first conductivity type may be positioned on one side (the back surface as an example) of the semiconductor substrate 110. As an example, the tunneling layer 22 may be formed on the semiconductor substrate 110, and the first conductive region 20 may be formed on the tunneling layer 22.

As an example, the tunneling layer 22 is in contact with and formed on the back surface of the semiconductor substrate 110, thereby simplifying a structure and improving a tunneling effect. In this case, the tunneling layer 22 may be entirely formed in the back surface of the semiconductor substrate 110. Herein, "entirely formed" may include not only a case where the entire back surface is covered by the tunneling layer without any blank, but also a case where a portion of the back surface is inevitably not covered. Accordingly, the tunneling layer 22 can be easily formed without any additional patterning process. However, the present disclosure is not limited thereto.

The tunneling layer 22 may act as a barrier to electrons and holes so as not to allow minority carriers to pass, and after accumulation in a portion adjacent to the tunneling layer 22, only majority carriers with energy above a predetermined amount pass through the tunneling layer 22. In this case, the majority carriers with energy above the predetermined amount can easily pass through the tunneling layer 22 due to a tunneling effect. In addition, the tunneling layer 22 may function as a diffusion barrier to prevent diffusion of the dopant in the first conductive region 20 into the semiconductor substrate 110. The tunneling layer 22 may include a variety of materials that allow the majority carriers to tunnel, and as an example, may include an oxide, a nitride, a semiconductor, a conductive polymer, and the like. In particular, the tunneling layer 22 may be composed of a silicon oxide layer composed of a silicon oxide. This is because the silicon oxide layer is a film with excellent passivation properties, and the carriers are easy to tunnel through the silicon oxide layer.

A thickness of the tunneling layer 22 may be less than that of the first passivation film 24, the second passivation film 34, the first conductive region 20, or the second conductive region 30 so as to fully achieve the tunneling effect. As an example, the thickness of the tunneling layer 22 may be less than 2 nm, and as an example, may range from 0.1 nm to 1.5 nm (e.g., 0.5 nm to 1.5 nm). When the thickness of the tunneling layer 22 exceeds 2 nm, the tunneling cannot occur smoothly, so efficiency of the solar cell 100 may be reduced, and when the thickness of the tunneling layer 22 is less than 0.1 nm, it may be difficult to form the tunneling layer 22 with desired quality. For a sufficient tunneling effect, the thickness of the tunneling layer 22 may range from 0.1 nm to 1.5 nm (e.g., 0.5 nm to 1.5 nm). However, the present disclosure is not limited thereto, and the thickness of the tunneling layer 22 may have various values.

The first conductive region 20 may be a region including the first-conductivity-type dopant to have the first conductivity type. As an example, the first conductive region 20 may be in contact with and formed on the tunneling layer 22, thereby simplifying the structure of the solar cell 100 and maximizing the tunneling effect of the tunneling layer 22. However, the present disclosure is not limited thereto.

The first conductive region 20 may include a same semiconductor material as the semiconductor substrate 110 (e.g., a single semiconductor material, silicon as an example). Then, the second conductive region 30 may have properties similar to those of the semiconductor substrate 110, thereby minimizing a difference in properties that may occur when semiconductor materials different from each other are included. However, since the first conductive region 20 is formed separately from the semiconductor substrate 110 on the semiconductor substrate 110, the first conductive region 20 may have a crystal structure different from that of the semiconductor substrate 110 so as to be easily formed on the semiconductor substrate 110.

For example, the first conductive region 20 may be formed by doping the first-conductivity-type dopant on an amorphous semiconductor, a microcrystalline semiconductor, a polycrystalline semiconductor (amorphous silicon, microcrystalline silicon, or polycrystalline silicon as an example), or the like, which may be easily manufactured by various methods such as deposition. In particular, the first conductive region 20 may include a polycrystalline semiconductor (polycrystalline silicon as an example). Then, due to excellent electrical conductivity, the carriers can move smoothly and smoothly tunnel through the tunneling layer 22 composed of an oxide or the like.

In this embodiment, the first conductive region 20 is formed independently of the semiconductor substrate 110, and defects or a low open-circuit voltage that may occur when a doping region inside the semiconductor substrate 110 is formed can be reduced. Accordingly, the open-circuit voltage of the solar cell 100 can be increased.

As shown in FIG. 1, the first conductive region 20 as described above can be entirely formed on the back surface of the semiconductor substrate 10. In this case, the first conductive region 20 includes a first part 23 below an electrode region where a first electrode 42 to be described later is formed, and a second part 21 which is a part other than the first part 23.

The first part 23 may be formed across the semiconductor substrate 10 in a bar type having a predetermined width w1 along a shape of the electrode 42, and the second part 21 may be formed between the first part 23 and an adjacent first part 23.

The first part 23 is in a bar type having a first width w1 and formed in an electrode region, and the first width w1 has a larger value than a second width w2 of the first electrode 42 on the first part 23. As an example, the first part 23 of the first width w1 is formed to have a space of 5 µm to 100 µm with respect to two sides of the second width w2. Therefore, when the second width w2 of the first electrode 42 ranges from 80 µm to 120 µm, the first width w1 of the first part 23 may range from 100 µm to 320 µm. That is, the first electrode 42 is arranged on the first part 23, and such arrangement provides a margin for alignment.

The first part 23 and the second part 21 of the first conductive region 20 are formed by a same material and a same process, but have thicknesses different from each other.

Therefore, the first conductive region 20 is formed by a plurality of parts having different thicknesses for an entirety of the semiconductor substrate 10. The second part 21 occupying most of the back surface of the semiconductor substrate 10, as an example, more than 90% of the area, has a second thickness d2.

The second thickness d2 is less than 50 nm, preferably, a thin thickness less than 30 nm. Moreover, the second part 21 constitutes most of the area of the first conductive region 20 and has a very small amount free carriers remaining on the surface.

In a case where the first conductive region 20 doped with first-conductivity-type carriers at high concentration is formed very thick, a very large number of free carriers remain on the entire back surface of the semiconductor substrate 10.

When a thick first conductive region 20 is formed on the back surface of the semiconductor substrate 10, the free carriers as described above absorb long wavelengths (in particular, long wavelengths ranging from 900 nm to 1200 nm) of light, the photoelectric efficiency is significantly reduced due to the absorption of the long wavelengths.

In order to prevent the phenomenon as described above, the thickness of the second part 21 occupying most of the semiconductor substrate 10 is formed to satisfy the second thickness d1, that is, below 50 nm.

In this case, the first part 23 corresponding to the electrode is formed to satisfy the first thickness d1 thicker than the second thickness d2.

The first thickness d1 (a distance from a top of the tunneling layer 22 to a bottom of the first electrode 42) may range from 100 nm to 200 nm, preferably range from 150 nm to 200 nm.

As described above, the first part 23 and the second part 21 have a thickness difference of 2 times to 8 times to constitute a step, thereby having properties required by each region.

That is, the first part 23 in ohmic contact with the first electrode 42 can prevent penetration and migration of a metal component into the lower tunneling layer 22 due to metal penetration during firing of the first electrode 42 in the first part 23, thereby maintaining the tunneling effect.

In addition, the second part 21 not in contact with the first electrode 42 is formed in a large area to maintain a thin thickness while reducing sheet resistance, so that excessive distribution of free carriers can be eliminated to block long-wavelength absorption. Therefore, an effect of simultaneously preventing recombination losses due to the tunneling effect and reduction in the photoelectric efficiency due to the long-wavelength absorption is achieved.

In addition, as the sheet resistance decreases, the open-circuit voltage becomes higher, and the short-circuit current also becomes higher.

Unlike the first conductive region 20 having the step as described above, the second conductive region 30 having the second conductivity type may be flatly formed on the other side (the front surface as an example) of the semiconductor substrate 110. As an example, in this embodiment, the second conductive region 30 may be a doping region formed by doping part of the semiconductor substrate 110 with a second-conductivity-type dopant. Then, the base region 10 and the second conductive region 30 may include a crystal structure and a semiconductor material the same as those of the semiconductor substrate 110, but have conductivity types that may be different from each other or doping concentration that may be different from each other. For example, in a case where the base region 10 has the first conductivity type, the conductivity types of the base region 10 and the second conductive region 30 are different from each other, and in a case where the base region 10 has the second conductivity type, the doping concentration of the second conductive region 30 is higher than that of the base region 10.

When the base region 10 has the first conductivity type, the first conductive region 20 having the first conductivity type constitutes a back surface field (BSF) region for providing a back surface field that has higher doping concentration than the semiconductor substrate 110 while has a same conductivity type as the semiconductor substrate 110, and the second conductive region 30 having the second conductivity type constitutes an emitter region having a different conductivity type from the base region 10 and forming a pn junction with the base region 10. Then, the second conductive region 30 constituting the emitter region is located on the front surface of the semiconductor substrate 110, so a path of light joining the pn junction can be minimized.

However, the present disclosure is not limited thereto. As another example, when the base region 10 has the second conductivity type, the first conductive region 20 constitutes an emitter region, and the second conductive region 30 constitutes a front surface field (FSF) region that has higher doping concentration than the semiconductor substrate 110 and a same conductivity type as the semiconductor substrate 110, and provides a front surface field.

As the first-conductivity-type dopant or the second-conductivity-type dopant, a p-type dopant may include Group-Ill elements such as boron (B), aluminum (Al), gallium (Ga), and indium (In), and an n-type dopant may include Group-V elements such as phosphorus (P), arsenic (As), bismuth (Bi), and antimony (Sb). However, the present disclosure is not limited thereto, and a variety of dopants may be used as the first-conductivity-type dopant or the second-conductivity-type dopant.

Herein, in this embodiment, the first conductive region 20 formed individually from the semiconductor substrate 110 is located on the back surface of the semiconductor substrate 110, and the second conductive region 30 constituting part of the semiconductor substrate 110 is located on the front surface of the semiconductor substrate 110. When the first conductive region 20 having a crystal structure different from that of the semiconductor substrate 110 is located on the front surface of the semiconductor substrate 110, the amount of light reaching the pn junction is reduced due to the light absorption in the first conductive region 20. Therefore, the first conductive region 20 is positioned on the back surface of the semiconductor substrate 110. However, the present disclosure is not limited thereto.

An insulating film may be formed on the entirety of the first conductive region 20 and the entirety of the second conductive region 30 except for opening portions 102 and 104 corresponding to the first electrode 42 and the second electrode 44. Such an insulating film may be composed of a non-doped insulating film including no dopant.

For example, a first insulating film may be formed (in contact with as an example) on the entirety of the first conductive region 20 excluding the opening portion 102, and a second insulating film may be formed (in contact with as an example) on the entirety of the second conductive region 30 excluding the opening portion 104. In this embodiment, it is exemplified that the first passivation film 24 and the first antireflection film 26 formed (in contact with as an example) on the first conductive region 20 are used as the first insulating film, and the second passivation film 34 formed (in contact with as an example) on the second conductive region 30 and the second antireflection film 36 formed (in contact with as an example) thereon are used as the second insulating film. However, the present disclosure is not limited thereto, and the insulating film may be arranged variously depending on desired functions.

The passivation films 24 and 34 are in contact with and formed in the conductive regions 20 and 30, thereby passivating defects present in surfaces or bodies of the conductive regions 20 and 30. Accordingly, recombination sites of minority carriers can be removed to increase an open-circuit voltage Voc of the solar cell 100. The antireflection film 36 reduces reflectivity of light incident on the front surface of the semiconductor substrate 110. Accordingly, an amount of light reaching the pn junction formed at an interface between the base region 10 and the first conductive region 20 can be increased by reducing reflectivity of light incident through the front surface of the semiconductor substrate 110. Therefore, a short-circuit current Isc of the solar cell 100 can be increased. The efficiency of the solar cell 100 can be improved by increasing the open-circuit voltage and the short-circuit current of the solar cell 100 through the passivation films 24 and 34 and the antireflection films 26 and 36 as described above.

As an example, each of the passivation films 24 and 34 or the antireflection films 26 and 36 may be a single film or a multilayer structure including one or more films selected from a group consisting of a silicon nitride film, a silicon nitride film containing hydrogen, a silicon oxide film, a silicon oxynitride film, an aluminum oxide film, MgF₂, ZnS, TiOz, and CeO₂. As an example, the passivation films 24 and 34 may include a silicon oxide film, a silicon nitride film, or the like having fixed positive charges when the conductive regions 20 and 30 are n-type, and may include an aluminum oxide film or the like having fixed negative charges when the conductive regions 20 and 30 are p-type. As an example, the antireflection films 26 and 36 may include silicon nitride. However, the present disclosure is not limited thereto, and the passivation films 24 and 34 and the antireflection films 26 and 36 may include a variety of materials.

The first electrode 42 is positioned (in contact with as an example) on the first part 23 of the first conductive region 20 and is electrically connected to the first part 23 of the first conductive region 20. The first electrode 42 may be electrically connected to the first conductive region 20 through the opening part 102 formed in the first antireflection film 26 and the first passivation film 24 (i.e., penetrating through the first passivation film 24 and the first antireflection film 26). Similarly, the second electrode 44 is positioned (in contact with as an example) on the second conductive region 30 and is electrically connected to the second conductive region 30. The second electrode 44 may be electrically connected to the first conductive region 20 through the opening part 104 formed in the second antireflection film 34 and the second passivation film 36 (i.e., penetrating through the second passivation film 34 and the second antireflection film 36). The first electrode 42 and the second electrode 44 may include a variety of materials (e.g., metals) and have a variety of shapes. Shapes of the first electrode 42 and the second electrode 44 will be described in detail later with reference to FIG. 2.

The tunneling layer 22 and the first conductive region 20 on the back surface of the semiconductor substrate 110 are positioned to be spaced apart from an edge of the back surface of the semiconductor substrate 110 (or a side surface of the semiconductor substrate 110). Therefore, an area of either of the tunneling layer 22 and the first conductive region 20 may be smaller than that of the semiconductor substrate 110.

The first passivation film 24 may extend onto the side surface of the semiconductor substrate 110, but is not limited thereto.

A planar shape of the first electrode 42 is described in detail with reference to FIG. 2.

Referring to FIG. 2, the first electrode 42 may include a plurality of finger electrodes 42a spaced apart from each other by a predetermined pitch. Although it is illustrated in the figure that the finger electrodes 42a are parallel to each other and parallel to edges of the semiconductor substrate 110, the present disclosure is not limited thereto. In addition, the first electrode 42 may include busbar electrodes 42b formed in a direction intersecting the finger electrodes 42a and connected to the finger electrodes 42a. Only one busbar electrode 42b may be provided, or a plurality of busbar electrodes 42b may be provided while having a pitch larger than that of the finger electrodes 42a as shown in FIG. 2. In this case, a width of the busbar electrode 422 may be greater than that of the finger electrode 422a, but the present disclosure is not limited thereto. Therefore, the width of the busbar electrode 422 may be equal to or less than that of the finger electrode 422a.

When viewed in cross sections, both the finger electrode 42a and the busbar electrode 42b of the first electrode 42 may be formed to penetrate through the first antireflection film 26 and the first passivation film 24. That is, the opening portion 102 may be formed corresponding to the finger electrode 42a and the busbar electrode 42b of the first electrode 42. However, the present disclosure is not limited thereto. As another example, the finger electrode 42a of the first electrode 42 may be formed to penetrate through the first antireflection film 26 and the first passivation film 24, and the busbar electrode 42b may be formed on the first antireflection film 26 and the first passivation film 24. In this case, the opening portion 102 may be formed in a shape corresponding to the finger electrode 42a, and may not be formed at a part where only the busbar electrode 42b is positioned.

In addition, the second electrode 44 may include a finger electrode and a busbar electrode corresponding to the finger electrode 42a and the busbar electrode 42b of the first electrode 42, respectively. The finger electrode and the busbar electrode of the second electrode 44 may be applied as the content of the finger electrode 42a and the busbar electrode 42b of the first electrode 42. In addition, the content about the first antireflection film 26 and the first passivation film 24 in the first electrode 42 may be applied to the second passivation film 34 and the antireflection film 36 in the second electrode 44. In this case, widths, pitches, and the like of the finger electrode 42a and the busbar electrode 42b of the first electrode 42 may also be the same as or different from those of the finger electrode and the busbar electrode of the second electrode 44.

However, the present disclosure is not limited thereto, the planar shapes of the first electrode 42 and the second electrode 44 may be different from each other, and various other modifications are possible.

As described above, in this embodiment, the first electrode 42 and the second electrode 44 of the solar cell 100 each have a predetermined pattern, so the solar cell 100 has a bi-facial structure in which light may be incident to the front surface and the back surface of the semiconductor substrate 110. Accordingly, an increase in an amount of light used in the solar cell 100 may improve efficiency of the solar cell 100. However, the present disclosure is not limited thereto, and in some embodiments, the first electrode 42 may have a structure formed on the entire back surface of the semiconductor substrate 110. Various other modifications are possible.

As described above, in the solar cell 100 according to some embodiments of the present disclosure, the first conductive region 20 on the back surface is formed by the first part 23 and the second part 21 having thicknesses different from each other, and the first part 23 having a greater thickness is arranged in alignment with the first electrode 42.

As described above, the conductive region 20 aligned with the electrode 42 may be formed thickly to protect the tunneling layer 22 from penetration of the fired metal material according to the electrode 42, and the second part 21 can be formed thinly to prevent long-wavelength light absorption according to FCA. Moreover, the sheet resistance may be low, thereby leading to a high open-circuit voltage and a large short-circuit current.

A method for manufacturing the solar cell 100 is described in detail with reference to FIG. 4a to FIG. 4j. The described content will not be described in details, and only content not described will be described in detail.

FIG. 4a to FIG. 4j are cross-sectional views of a solar cell manufacturing method according to some embodiments of the present disclosure.

As shown in FIG. 4a, a texturing process is performed on the front surface and the back surface of the semiconductor substrate 110 to form unevenness. Wet or dry texturing may be used for the texturing of the surface of the semiconductor substrate 110. The wet texturing may be performed by immersing the semiconductor substrate 110 in a texturing solution, and has an advantage of a short process time. In the dry texturing, the surface of the semiconductor substrate 110 is cut using a diamond grill, a laser, or the like, which may uniformly form the unevenness, but may have a long process time and cause damages to the semiconductor substrate 110. In addition, the semiconductor substrate 110 may be textured by reactive ion etching (RIE) or the like. As described above, in the present disclosure, the semiconductor substrate 110 may be textured by various methods.

For simplified illustration, it is shown in the figure that no unevenness by texturing is provided on the side surface of the semiconductor substrate 110. In addition, since the thickness of the semiconductor substrate 110 is very small, it may also be difficult to clearly recognize the unevenness by texturing. However, the present disclosure is not limited thereto. In some embodiments, unevenness by texturing may be provided on the side surface of the semiconductor substrate 110. In addition, the texturing of the semiconductor substrate 110 may be performed in a subsequent process.

As shown in FIG. 4b, the tunneling layers 22 are entirely formed on the two sides of the semiconductor substrate 110. In this case, the tunneling layer 22 may also be entirely formed on the side surface of the semiconductor substrate 110.

Herein, as an example, the tunneling layer 22 may be formed by thermal oxidation, chemical oxidation, deposition (atmospheric pressure chemical vapor deposition (APCVD) or low pressure chemical vapor deposition (LPCVD) as an example), or the like. In some embodiments, after the tunneling layer 22 is formed to have a thin thickness, the thickness or density of the tunneling layer 22 may be increased by subsequent heat treatment in a furnace or the like. However, the present disclosure is not limited thereto, and the tunneling layer 22 may be formed by various methods. Herein, the tunneling layer 22 may be composed of a silicon oxide layer.

As an example, in this embodiment, the tunneling layer 22 may be formed in a gas atmosphere including a raw gas at a temperature lower than room temperature and pressure lower than atmospheric pressure. In this embodiment, the raw gas may include an oxygen gas, and the tunneling layer 22 may be composed of an oxide layer. For example, at a high temperature, the tunneling layer 22 may be composed of a thermal oxide material (e.g., thermal silicon oxide) layer formed by reaction of oxygen with a semiconductor material (e.g., silicon) of the semiconductor substrate 110.

In this case, in this embodiment, the raw gas does not include all the raw materials constituting the tunneling layer 22, only includes the oxygen gas in the oxide constituting the tunneling layer 22, and does not include other raw materials. For example, when the tunneling layer 22 includes a silicon oxide, only the oxygen gas is provided as a raw material, and a gas containing silicon as another raw material is not included. Therefore, oxygen of the oxygen gas diffuses into the interior of the semiconductor substrate 110 to form the tunneling layer 22 through a thermal oxidation process reacting with the semiconductor material. In some other embodiments, an oxygen gas containing oxygen and a silane (SiH₄) gas containing silicon are supplied together as raw gases in a deposition process or the like. Then, oxygen separated from the oxygen gas and silicon separated from the silane gas undergo a chemical reaction through thermal decomposition to form a silicon oxide. When the tunneling layer 22 is formed, the gas atmosphere may contain various gases in addition to the oxygen gas as the raw gas.

In addition, pressure for forming the tunneling layer 22 becomes lower than the atmospheric pressure, and a growth rate of the tunneling layer 22 may be kept low by low pressure even though the tunneling layer 22 is formed by a thermal oxidation process according to a relatively high temperature (above 600°C as an example). Accordingly, the thickness of the tunneling layer 22 may be significantly reduced. As an example, when the tunneling layer 22 is formed, the temperature is set to 600°C to 800°C and the pressure is below 600 Torr, so that the thickness of the tunneling layer 22 can be effectively reduced.

As described above, in this embodiment, when the tunneling layer 22 is formed, since there is a need to control the temperature and the pressure together, the tunneling layer 22 of this embodiment cannot be formed in a conventional furnace where the pressure cannot be adjusted, and the tunneling layer 22 is required to be formed in an apparatus where both the temperature and the pressure can be adjusted. Accordingly, in this embodiment, the tunneling layer 22 may be formed through a thermal oxidation process inside a deposition apparatus or the like. In this case, due to the need to achieve the low pressure, the tunneling layer 22 can be formed in a low pressure chemical vapor deposition apparatus.

Since the semiconductor layer formed on the tunneling layer 22 is formed by the deposition apparatus, when the tunneling layer 22 is formed in the deposition apparatus, the tunneling layer 22 and an intrinsic semiconductor layer 200 may be formed by an in-situ process continuously performed in a same deposition apparatus (e.g., the low pressure chemical vapor deposition apparatus). As described above, when the tunneling layer 22 and the intrinsic semiconductor layer 200 are formed by the in-situ process, the manufacturing process can be greatly simplified, so that a manufacturing cost and a manufacturing time can be greatly reduced.

The temperature inside the deposition apparatus can be adjusted by heating or cooling for a long time, and it takes a lot of time to stabilize the temperature, whereas the gas atmosphere and the pressure can be adjusted according to a kind, an amount, and the like of the gas supplied into the deposition apparatus. Therefore, the gas atmosphere and the pressure can be controlled more easily than the temperature.

In consideration of this, in this embodiment, a difference between a formation temperature of the tunneling layer 22 and a temperature of the deposition process of the intrinsic semiconductor layer 200 may be within 200°C (i.e., 0°C to 200°C). For example, the difference between the formation temperature of the tunneling layer 22 and the temperature of the deposition process of the intrinsic semiconductor layer 200 may be within 100°C (i.e., 0° C to 100°C). This is because the formation temperature of the tunneling layer 22 can be relatively increased due to the formation of the tunneling layer 22 at the low pressure, thereby reducing the difference with the temperature of the deposition process of the intrinsic semiconductor layer 200. As described above, the relatively difficult-to-adjust temperature can be maintained without much change, thereby further improving the efficiency of the in-situ process for continuously forming the tunneling layer 22 and the intrinsic semiconductor layer 200. Conversely, the gas atmosphere of the deposition process of the intrinsic semiconductor layer 200 may be different from the gas atmosphere in which the tunneling layer 22 is formed, and the pressure of the deposition process of the intrinsic semiconductor layer 200 may be the same as or different from the pressure at which the tunneling layer 22 is formed. This will be described in more detail later when the deposition process of the intrinsic semiconductor layer 200 is described.

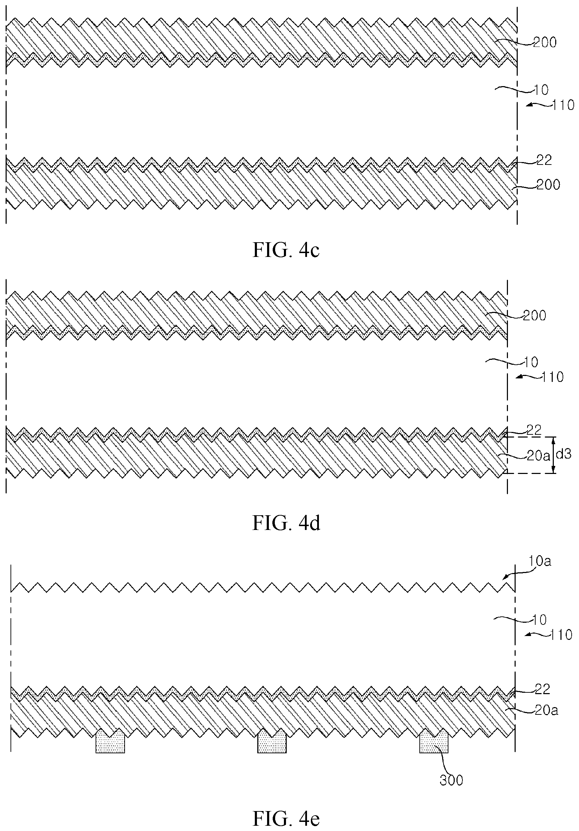

As shown in FIG. 4c, the intrinsic semiconductor layers 200 are entirely formed on the tunneling layers 22 on two sides of semiconductor substrate 110. In this case, the intrinsic semiconductor layer 200 may be entirely formed on the tunneling layer 22 on the side surface of the semiconductor substrate 110. As described above, when the intrinsic semiconductor layer 200 is located on the two sides, doping of, damages to, or the like of the front surface of the semiconductor substrate 110 in the process of doping the first conductive region 20 can be effectively prevented.

In this embodiment, the intrinsic semiconductor layer 200 may be formed by chemical vapor deposition, and in some embodiments, may be formed by LPCVD. Therefore, as described above, the intrinsic semiconductor layer 200 and the tunneling layer 22 may be formed through the in-situ process. However, the present disclosure is not limited thereto, and the in-situ process may not be applied to the tunneling layer 22 and the intrinsic semiconductor layer 200.

The gas used in the deposition process of the intrinsic semiconductor layer 200 may include a gas containing a semiconductor material constituting the intrinsic semiconductor layer 200 (e.g., a silane gas). In this embodiment, since the intrinsic semiconductor layer 200 is deposited in order to be intrinsic, the gas atmosphere may be composed only of a gas containing a semiconductor material. Accordingly, a supplied gas can be simplified, and purity of the formed intrinsic semiconductor layer 200 can be improved. However, the present disclosure is not limited thereto, and the deposition process of the intrinsic semiconductor layer 200 may be facilitated, or an additional gas for improving properties of the intrinsic semiconductor layer 200 or the like may be used. In addition, in the deposition process of the intrinsic semiconductor layer 200, in addition to the gas containing the semiconductor material, a nitrogen oxide (N₂O) gas and/or an oxygen (O₂) gas may also be supplied together to adjust a grain size, crystallinity, and the like.

A deposition temperature of the intrinsic semiconductor layer 200 may be the same as or lower than the formation temperature of the tunneling layer 22. In particular, when the deposition temperature of the intrinsic semiconductor layer 200 is lower than the formation temperature of the tunneling layer 22, the properties of the intrinsic semiconductor layer 200 directly involved in photoelectric conversion may be uniform. In some other embodiments, the deposition temperature of the intrinsic semiconductor layer 200 may range from 500 °C to 700°C. The deposition temperature is defined as a temperature suitable for deposition of the intrinsic semiconductor layer 200 having a crystal structure different from that of the semiconductor substrate 110. As described above, since the temperature of the tunneling layer 22 is the same or similar to the deposition temperature of the intrinsic semiconductor layer 200, the time for adjusting the temperature, the time for stabilizing the temperature, and the like are not required, thereby simplifying the process.

In addition, deposition pressure of the intrinsic semiconductor layer 200 may be lower than the atmospheric pressure, and as an example, may be 600 Torr or less (1 Torr to 600 Torr as an example). The deposition pressure kept at less than 1 Torr may have a technological limit, and the process time of the intrinsic semiconductor layer 200 may be significantly prolonged, so it may be difficult to apply to actual mass production. When the deposition pressure exceeds 600 Torr, uniformity of the intrinsic semiconductor layer 200 may be reduced. In some other embodiments, the deposition pressure of the intrinsic semiconductor layer 200 may be the same as or lower than the formation pressure of the tunneling layer 22. In particular, when the deposition pressure of the intrinsic semiconductor layer 200 is lower than the formation pressure of the tunneling layer 22, the properties of the intrinsic semiconductor layer 200 directly involved in the photoelectric conversion may be uniform.

A detailed description thereof is provided below. The intrinsic semiconductor layer 200 is formed by depositing a semiconductor material onto the tunneling layer 22 by thermally decomposing a gas containing a semiconductor material (e.g., silicon). However, when the temperature and/or the pressure are/is increased in order to increase a deposition rate, dispersion of crystallinity inside the intrinsic semiconductor layer 200 becomes large. Since the crystallinity of the intrinsic semiconductor layer 200 affects a mobility of carriers or the like, when the dispersion of the crystallinity of the intrinsic semiconductor layer 200 becomes large, the properties of the intrinsic semiconductor layer 200 may become non-uniform. Conversely, the tunneling layer 22 is formed to have a very thin thickness, and the crystallinity does not have a great influence on the properties of the tunneling layer 22. In consideration of this, although the intrinsic semiconductor layer 200 is required to be formed to have a thicker thickness than the tunneling layer 22, there is a need to set the deposition temperature and/or the pressure of the intrinsic semiconductor layer 200 to be lower than the formation temperature and/or pressure of the tunneling layer 22, thereby improving the properties of the intrinsic semiconductor layer 200.

However, the present disclosure is not limited thereto, and the gas atmosphere, the temperature, the pressure, and the like of the intrinsic semiconductor layer 200 may be varied in many manners.

As described above, the intrinsic semiconductor layer 200 may be formed by changing the type of the gas supplied after the formation of the tunneling layer 22 and adjusting an amount of the gas supplied. For example, after the formation of the tunneling layer 22 is completed, the gas (e.g., an oxygen gas, a nitrogen gas, a chlorine gas, and the like) used in the formation of the tunneling layer 22 is removed by pumping and purge, and then a gas for forming the intrinsic semiconductor layer 200 (e.g., a gas containing a semiconductor material, or the like) is supplied, such that the intrinsic semiconductor layer 200 is formed.

Therefore, the formation process of the tunneling layer 22 and the intrinsic semiconductor layer 200 can be simplified. In addition, as conventionally, when the semiconductor substrate formed with the tunneling layer is taken to the outside of the apparatus after the formation of the tunneling layer, the tunneling layer may polluted by impurities or the thickness of the tunneling layer becomes thicker due to additional oxidation. In this embodiment, since the intrinsic semiconductor layer 200 is continuously formed within the apparatus where the tunneling layer 22 is formed, the tunneling layer 22 is not exposed to the outside before the intrinsic semiconductor layer 200 is formed. Therefore, a problem that the tunneling layer 22 is exposed to the outside before the intrinsic semiconductor layer 200 is formed can be prevented.

For reference, in the case of plasma enhanced chemical vapor deposition (PECVD), in order to have a polycrystalline structure after the formation of the intrinsic semiconductor layer 200, an additional crystallization annealing process is performed. Accordingly, the structure may become complicated and the performance may also be degraded. In addition, it may be difficult to entirely form the intrinsic semiconductor layers 200 on the two sides of the semiconductor substrate 110 through a single-sided process using PECVD.

Next, as shown in FIG. 4d, at least the intrinsic semiconductor layer 200 on the back surface of the semiconductor substrate 110 is doped with the first-conductivity-type dopant to form the first conductive region 20a. In this case, in this embodiment, the first-conductivity-type dopant may be doped by thermal diffusion. This is because doping by thermal diffusion can be performed while degradation of the properties of the tunneling layer 22 is minimized. Conversely, is ion implantation and the like is used, the properties of the tunneling layer 22 may be degraded due to the activation heat treatment at a high temperature after the ion implantation.

As an example, as shown in FIG. 4d, the first conductive region 20a may be entirely formed by performing the heat treatment in a gas atmosphere containing the first-conductivity-type dopant. In a case where the first conductive region 20a has an n type, the heat treatment may be performed in a gas atmosphere containing POCl\₃. In some embodiments, in a case where the first conductive region 20a has a p type, the heat treatment may be performed in a gas atmosphere containing BBr₃.

As described above, the process of forming the first conductive region 20a by using the gas containing the first conductivity-type dopant may be simplified. However, through this process, the back surface of the semiconductor substrate 110 is doped, and the front surface and the side surface of the semiconductor substrate 110 are also doped. In this embodiment, since parts of the intrinsic semiconductor layer 200 are formed on the front surface and the side surface of the semiconductor substrate 110 and will be removed by subsequent processes, the front surface and the side surface of the semiconductor substrate 110 can be prevented from being unnecessarily doped with the first-conductivity-type dopant. The first conductive region 20a formed as described above has a third thickness d3. The third thickness d3 may have a same value as or a larger value than the first thickness d1.

Next, as shown in FIG. 4e, the intrinsic semiconductor layers 200 formed in regions other than the first conductive region 20a on the back surface of the semiconductor substrate 110 are completely removed to expose a concave-convex portion 10a on the front surface of the semiconductor substrate 110. The front surface of the semiconductor substrate 110 as described above may be exposed by etching, for example, by RIE, but is not limited thereto.

As shown in FIG. 4e, when the concave-convex portion 10a is exposed to the front surface of the substrate 10, a mask layer 300 configured to form a step structure of the first conductive region 20a on the intrinsic semiconductor layer 200 on the back surface is formed.

The mask layer 300 may be formed in a region where the first part 23 is to be formed in the first conductive region 20 in FIG. 1. The mask layer 300 may include a material that is not removed in a process of removing the first conductive region 20a including the semiconductor material. For example, the unetched mask layer 300 in an etching solution used in the process of removing the first conductive region 20a may contain an oxide, a nitride, resin, and the like. As an example, the mask layer 300 is composed of a silicon nitride layer, so that the mask layer 300 may be formed through a simple process.

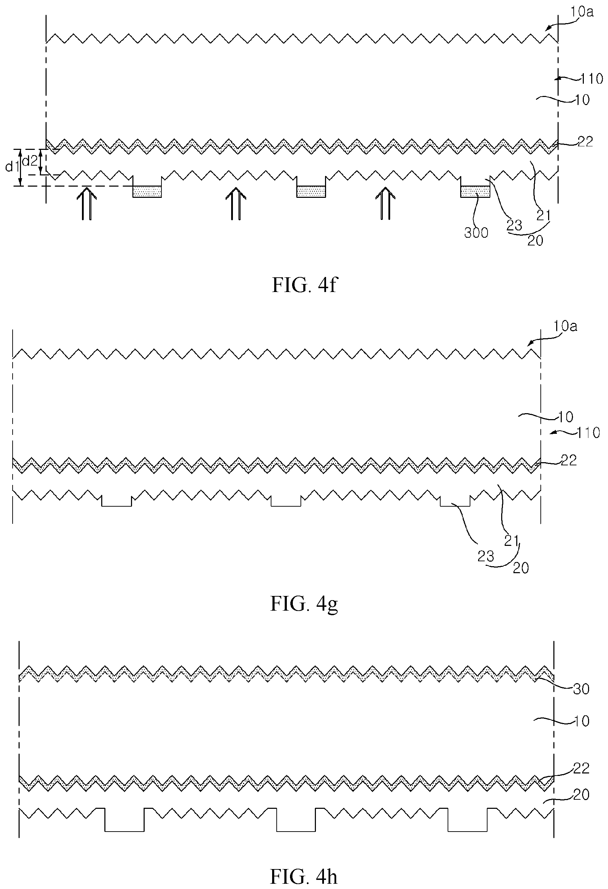

Next, as shown in FIG. 4f, only the second part 21 of the first conductive region 20 not covered by the mask layer 300 is etched to a predetermined depth to form, in the first conductive region 20, the first part 23 having the first thickness d1 and the second part 21 having the second thickness d2.

As described above, the first conductive region 20 is formed by the first part 23 and the second part 21 having different thicknesses to constitute a step.

As an example, the step as described above may be formed by wet etching by using an alkaline solution (a KOH solution as an example). According to the wet etching, the first conductive region 20 located in a region of the semiconductor substrate 110 other than the mask layer 300 may be removed through a simple and easy process. The first conductive region 20 may be selectively and easily reduced to the predetermined depth by using the alkaline solution. However, the present disclosure is not limited thereto. Part of the first conductive region 20 may be removed by various methods such as RIE, dry etching, or the like.

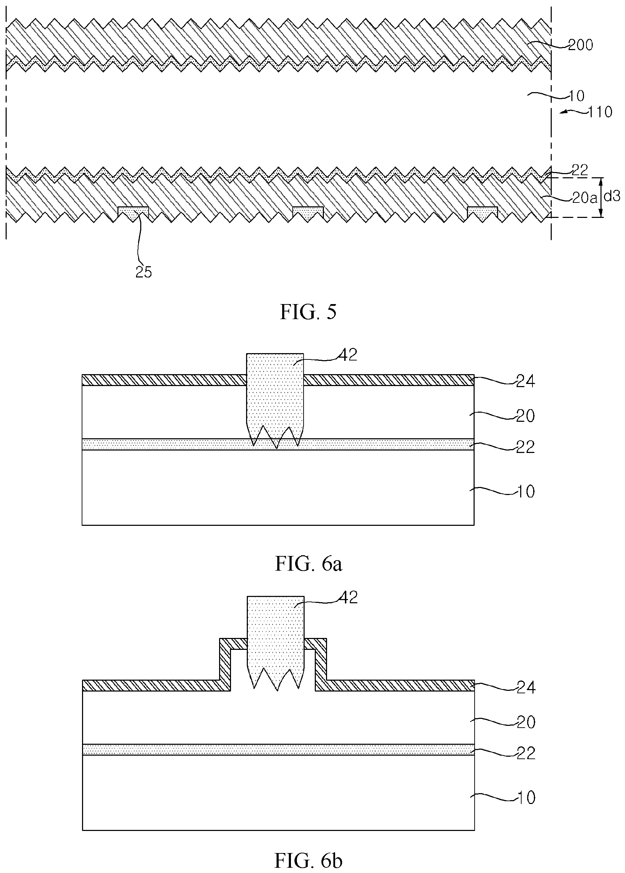

In this case, as shown in FIG. 5, instead of forming the mask layer 300 alone, crystallization is formed by laser along a region where the first part 23 of the first conductive region 20 is to be formed, thereby functioning as the mask layer.

With the crystallization of the first part 23 of the first conductive region in accordance with laser irradiation through laser patterning 25 as described above, immersion of the alkali solution has selective reactivity. Therefore, the first part 23 irradiated by the laser is not etched, and only the second part 21 is selectively etched, so that the step shown in FIG. 4f can be formed.

Referring to FIG. 4g again, the mask layer 300 may be removed after the step of the first conductive region 20 is formed. The mask layer 300 may be removed by various methods depending on materials. As an example, the mask layer 300, when including an oxide, a nitride, and the like, may be removed through a process by using diluted fluoric acid. In some embodiments, the mask layer 300 may be removed through an additional process, or may be naturally removed through a washing process including a solution containing diluted hydrofluoric acid. However, the present disclosure is not limited thereto, and the mask layer 300 may be removed by various known methods.

Next, as shown in FIG. 4h, the second conductive region 30 is formed on the front surface of the semiconductor substrate 110. The second conductive region 30 may be composed of a doping region constituting part of the semiconductor substrate 110 by doping the semiconductor substrate 110 with the second-conductivity-type dopant.

The second conductive region 30 may be formed by various known methods. For example, the second conductive region 30 may be formed by thermal diffusion. This is because doping by thermal diffusion can be performed while degradation of the properties of the tunneling layer 22 is minimized. Conversely, according to ion implantation and the like, the properties of the tunneling layer 22 may be degraded due to the activation heat treatment constituted at a high temperature after the ion implantation.

As an example, cover films (not shown) may be formed on the side surface and the back surface of the semiconductor substrate 110, and the second conductive region 30 is formed on the front surface of the semiconductor substrate 110 by heat treatment in a gas atmosphere containing the second-conductivity-type dopant. In a case where the second conductive region 20a has a p type, the heat treatment may be performed in a gas atmosphere containing BBr₃. In some embodiments, in a case where the second conductive region 30 has an n type, the heat treatment may be performed in a gas atmosphere containing POCl₃. The cover film may be removed after the formation of the second conductive region 30. Various films that may block the doping of the second-conductivity-type dopant may be used as the cover film, and the cover film may be removed by a removal method according to the material.

As another example, a second doping layer (not shown) containing the second-conductivity-type dopant may be formed on the front surface of the semiconductor substrate 110, and the second conductive region 30 may be formed by diffusing the second-conductivity-type dopant contained in the second doping layer into the interior of the semiconductor substrate 110 through heat treatment. As an example, the second doping layer may include boron silicate glass (BSG), phosphorus silicate glass (PSG), and the like. The second doping layer may be easily formed by deposition or the like. As an example, the second doping layer may be formed by APCVD or the like, and is not formed on the back surface of the semiconductor substrate 110.

When the heat treatment as described above is performed, the first-conductivity-type dopant of the first conductive region 20 may also be additionally activated in the first conductive region 20.

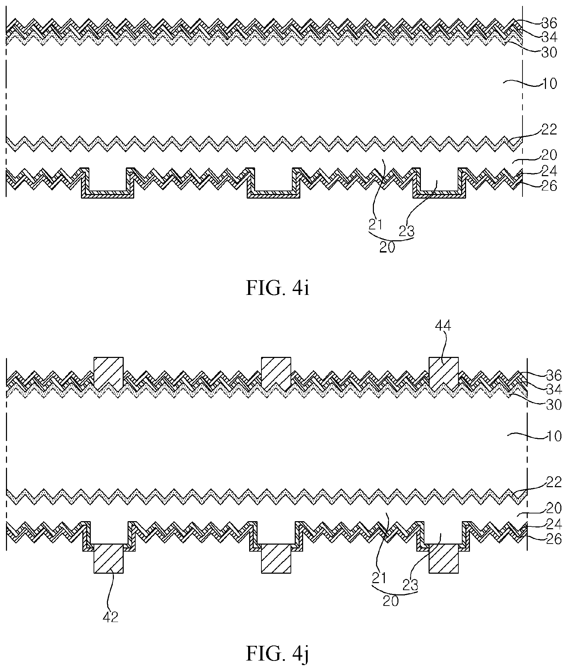

Next, as shown in FIG. 4i, insulating films are formed on the front surface and the back surface of the semiconductor substrate 110. For example, the first passivation film 24, the second passivation film 34, the first antireflection film 26, and the second antireflection film 36 are respectively formed on the front surface and the back surface of the semiconductor substrate 110. In this case, an insulating layer (i.e., the second passivation film 34 and the second antireflection film 36) may also be formed on the side surface of the semiconductor substrate 110. For example, at least part of the insulating film (the second passivation film 34 as an example) located on the front surface of the semiconductor substrate 110 may be in contact with the second conductive region 30.

The second passivation film 34 or the second antireflection film 36 may be formed by various methods such as vacuum deposition, chemical vapor deposition, spin coating, screen printing, or spray coating. In this case, when single-side deposition such as PECVD is used in the formation of the second passivation film 34 or the second antireflection film 36, the second passivation film 34 or the second antireflection film 36 may be formed only on the front surface and/or the side surface. Therefore, there is also no need to provide a separate patterning process for the second passivation film 34 or the second antireflection film 36.

Next, the first conductive region 20 is formed on the back surface of the semiconductor substrate 10 and the first passivation film 24 and the first antireflection film 26 are formed on the back surface of the semiconductor substrate 110.

For example, the first passivation film 24 may be formed on the first conductive region 20, that is, on an entirety of the back surface of the semiconductor substrate 110 along the step of the first part 23 and the second part 21.

As an example, the first passivation film 24 may be formed by various methods such as vacuum deposition, chemical vapor deposition, spin coating, screen printing, or spray coating. In this case, when single-side deposition such as PECVD is used in the formation of the first passivation film 24 or the first antireflection film 26, the first passivation film 24 may be formed only on the back surface and/or the side surface. Therefore, there is also no need to provide a separate patterning process for the first passivation film 24.

In this embodiment, it is exemplified that, after the insulating film covering the front surface of the semiconductor substrate 10 is first formed, the insulating film covering the back surface of the semiconductor substrate 10 is formed. However, the present disclosure is not limited thereto. That is, the first passivation film 24 and the second passivation film 34 may be formed on the front surface and the back surface at the same time, alternatively the first antireflection film 34 and the second antireflection film 36 may also be formed respectively. As described above, the first passivation film 24 and the second passivation film 34 may be formed by atomic layer deposition (ALD), and the first antireflection film 34 and the second antireflection film 36 may be formed by plasma ion deposition.

Next, as shown in FIG. 4j, the first electrode 42 and the second electrode 44 respectively connected to the first conductive region 20 and the second conductive region 30 are formed.

As an example, paste for forming the first electrode and the second electrode is applied to the corresponding insulating film by screen printing or the like, and then the first electrode 42 and the second electrode 44 of the above shapes may be formed by performing firing through or laser firing contact.

In this case, since the first opening 102 and the second opening 104 are naturally formed when the first electrode 42 and the second electrode 44 are formed, there is no need to add a process for separately forming the first opening 102 and the second opening 104.

In this case, the first electrode 42 is aligned to also be formed on the first part 23 of the first conductive region 20. The first width w1 of the first part 23 has a larger value than the second width w2 of the first electrode 42 on the first part 23. As an example, the first part 23 of the first width w1 is formed to have a space of 5 µm to 100 µm to two sides of the second width w2. Therefore, when the second width w2 of the first electrode 42 ranges from 80 µm to 120 µm, the first width w1 of the first part 23 may range from 100 µm to 320 µm. That is, when the first part 23 is formed to have a larger width and the first electrode 42 is arranged, an alignment error does not occur.

FIG. 6a and FIG. 6b are cross-sectional views of a portion below an electrode according to the present disclosure.

FIG. 6a shows a comparative example of the present disclosure, and FIG. 6b shows a case after firing through of the first electrode 42 according to some embodiments of the present disclosure.

Referring to FIG. 6a and FIG. 6b, after the firing through of the first electrode 42, a metal component of the first electrode 42 penetrates into the lower insulating layer 24 and the first conductive region 20.

An opening portion is formed in the insulating layer 24 and is in contact with the first conductive region 20 by the metal penetration into the portion below the first electrode 42 as described above. In this case, penetration into the first conductive region 20 is also formed, and in a case where the first conductive region 20 is formed thinly as shown in FIG. 6a, the penetration of the metal component as described above reaches the lower tunneling layer 22.

When the metal component of the first electrode 42 reaches the tunneling layer 22, the minority carriers may be recombined without expecting the tunneling effect, so that the photoelectric efficiency is drastically reduced.

In order to prevent this, according to the present disclosure, as shown in FIG. 6b, the first part 23 of the first conductive region 20 where the first electrode 42 is formed is formed very thickly to have the first thickness d1, and the second part 21 other than the first part is formed very thinly to have the second thickness d2.

As the first part 23 in contact with the electrode 42 is formed thickly as described above, the penetration of the metal component into the lower tunneling layer 22 can be prevented, so that the tunneling effect can be maintained.

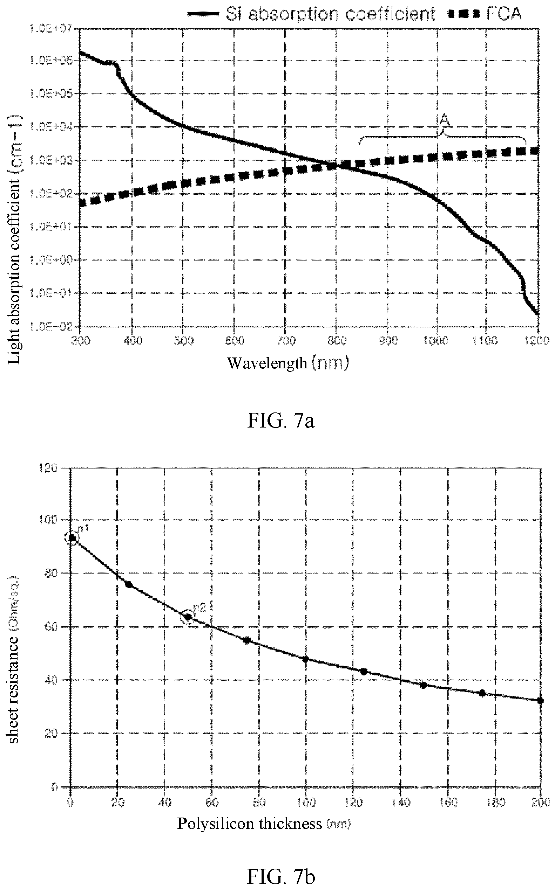

FIG. 7a and FIG. 7b are a graph for long-wavelength absorption in a surface of a conductive region and a graph showing sheet resistance according to a thickness of the conductive region.

In this case, FIG. 7a shows an absorption coefficient for an incident light wavelength for polysilicon of the first conductive region 20. In this case, when the wavelength is more than 800 nm, a section A in which the absorption coefficient suddenly increases may be observed.

This occurs when polysilicon is formed thicker than a predetermined thickness, and the long-wavelength absorption increases according to high-concentration free carriers present on the surface, and the absorption coefficient becomes larger as more free carriers are present.

As the doping concentration increases, more free carriers are present, so the absorption coefficient as described above becomes larger, which increases as the polysilicon layer is thicker.

Therefore, in order to prevent the FCA as described above, the second part 21 occupying most of the first conductive region 20 is formed so thinly as to have the second thickness d2. As described above, in the second part 21 with the thin thickness, there are almost no free carriers, so the FCA does not occur.

In addition, FIG. 7b shows sheet resistance of the surface for the thickness of the polysilicon.

As shown in FIG. 7b, film formation of polysilicon exhibits a tendency to decrease the sheet resistance when the thickness of the polysilicon is formed thickly (n1>n2). However, in order to reduce the FCA, in a case where there is no polysilicon at the second part 21 other than the lower portion of the electrode 42 so that the substrate is exposed, a same effect is achieved as in the case of removing resistance parts connected in parallel, so the surface resistance becomes high.

Therefore, as described in some embodiments of the present disclosure, the first part 23 at the lower portion of the electrode is formed thickly so that the surface resistance is kept low, and the first conductive region is also kept thinly in the second part 21 other than this, thereby increasing resistance components connected in parallel and reducing combined resistance. Therefore, when the solar cell is viewed as a whole, the resistance decreases, thereby making it easy to ensure FF.

The features, structures, effects, and the like above are included in at least one embodiment of the present disclosure, and are not necessarily limited to only one embodiment. In addition, the features, structures, effects, and the like exemplified in various embodiments can also be implemented by combining or modifying other embodiments by those of ordinary skill in the art to which the embodiments belong. Therefore, content related to such combinations and modifications should be construed as being included in the scope of the present disclosure.

## Claims

1. A solar cell, comprising:
a tunneling layer, wherein the tunneling layer is located on one side of a semiconductor substrate;
a first conductive region, wherein the first conductive region is located on the tunneling layer;
a first insulating film, wherein the first insulating film is located on and passivates the first conductive region;
a second conductive region, wherein the second conductive region is located at the other side of the semiconductor substrate and composed of a doping region;
a first electrode, wherein the first electrode is connected to the first conductive region; and
a second electrode, wherein the second electrode is connected to the second conductive region,
wherein the first conductive region comprises a first part connected to the first electrode and a second part other than the first part, and a thickness of the first part is different from that of the second part.

2. The solar cell according to claim 1, wherein a width of the first part is greater than that of the first electrode.

3. The solar cell according to claim 1, wherein the thickness of the first part is greater than that of the second part.

4. The solar cell according to claim 3, wherein the thickness of the first part ranges from 100 nm to 200 nm.

5. The solar cell according to claim 1, wherein the thickness of the second part is less than 50 nm.

6. The solar cell according to claim 1, wherein the first conductive region is arranged on a back surface of the semiconductor substrate and is doped with a dopant of a same conductivity type as the semiconductor substrate.

7. The solar cell according to claim 1, wherein unevenness is formed on one side and the other side of the semiconductor substrate.

8. The solar cell according to claim 7, further comprising: a second insulating film, wherein the second insulating film is located on the second conductive region.

9. A method for manufacturing a solar cell, comprising:
forming tunneling layers on one side and the other side of a semiconductor substrate respectively;
forming an intrinsic semiconductor layer on the tunneling layer on one side of the semiconductor substrate, and doping the intrinsic semiconductor layer with a first-conductivity-type dopant to form a first conductive region;
selectively partially etching a second part of the first conductive region other than a first part of the first conductive region to form a step;
doping the other side of the semiconductor substrate with a second-conductivity-type dopant to form a second conductive region composed of a doping region;
forming a first insulating film covering the first conductive region; and
forming electrodes, wherein the electrodes comprise a first electrode connected to the first part of the first conductive region and a second electrode connected to the second conductive region.

10. The method according to claim 9, wherein the step of forming a step in the first conductive region comprises:
forming a mask layer on the first part;
removing, using an etching solution, the exposed second part of the first conductive region to a predetermined thickness; and
removing the mask layer.

11. The method according to claim 9, wherein the step of forming a step in the first conductive region comprises:
irradiating the first part of the first conductive region with a laser to change a crystalline structure of the first part; and
etching the second part to a predetermined thickness.

12. The method according to claim 10 or 11, wherein, in the step of forming a step in the first conductive region, the first conductive region is immersed in an alkaline solution to be etched to have the step.

13. The method according to claim 9, further comprising: forming unevenness on two sides of the semiconductor substrate.

14. The method according to claim 13, wherein a width of the first part is formed to be greater than a width of the first electrode.

15. The method according to claim 14, wherein the step of forming a first electrode comprises:
coating the first insulating film on the first part with a metal paste; and
firing through the metal paste such that the metal paste penetrates through the first insulating film and is in contact with the first part.
